# EUROPEAN PATENT SPECIFICATION

(11) **EP 1 623 614 B1**
(45) Date of publication and mention of the grant of the patent: **17.01.2007**
(21) Application number: 04725109.5
(22) Date of filing: 01.04.2004
(51) Int. Cl.: H05K 13/00

(54) **DRY CABINETS FOR USE IN MOISTURE SENSITIVE DEVICE MANAGEMENT IN ELECTRONICS MANUFACTURING**
TROCKENSCHRANK ZUR BEHANDLUNG FEUCHTIGKEITSEMPFINDLICHER BAUTEILE IN DER ELEKTRONIKFERTIGUNG
ARMOIRE DE STOCKAGE A SEC UTILE POUR LA MANUTENTION DE DISPOSITIFS SENSIBLES A L'HUMIDITE DANS LA FABRICATION ELECTRONIQUE

(30) Priority: 02.05.2003 US 467314 P; 31.12.2003 US 750418
(43) Date of publication of application: 08.02.2006
(73) Proprietor: L'air liquide, Société anonyme à Directoire et Conseil de Surveillance pour l'Etude et l'Exploitation des Procédés G. Claude, 75321 Paris Cedex 07 (FR)
(72) Inventor: THERIAULT, Martin, Vanier, Quebec G1M 3M2 (CA)
(74) Representative: Mellul-Bendelac, Sylvie Lisette
(86) International application number: PCT/IB2004/000996
(87) International publication number: WO 2004/103050

(56) References cited:
- EP-A- 0 959 653
- US-A- 4 874 401
- US-A- 4 933 314
- US-A- 5 603 892

## Description

### FIELD OF THE INVENTION

The invention relates to improvements in the field of electronic packaging & assembly and the soldering of ICs or passive devices on printed circuit boards.

### BACKGROUND OF THE INVENTION

The ongoing integration and miniaturization of components for electronic circuitry has become a growing challenge to the limits of printed wiring board technology over the last twenty years. Printed circuit boards or printed wiring boards (PWB) as they are more commonly termed, play several key roles. First, the electrical components, such as specially packaged integrated circuits, resistors, etc., are mounted or carried on the surface of the flat usually sturdy card-like board. Thus, the PWB serves as a support for the components. Secondly, using chemically etched or plated conductor patterns on the surface of the board, the PWB forms the desired electrical interconnections between the components. In addition, the PWB can include a metal area serving as a heat sink.

Increased use of integrated circuits, and surface mount technology (SMT) has accelerated the densification of electronic circuitry. Surface mount devices (SMD) are applied directly to the surface of the PWB and soldered using vapor phase reflow (VPR), infra-red (IR) or other mass soldering techniques. SMT is revolutionizing the electronic manufacturing industry by reducing assembly cost by about 50%, increasing component density by over 40% and enhancing reliability.

In a conventional SMD package, a silicon die is mounted on a die pad of a multilayer organic substrate. The entire die pad area of the substrate is coated with an adhesive which bonds the silicon die to the substrate. Unfortunately, moisture inside a plastic SMD package turns to steam and expands rapidly when the package is exposed to the high temperatures of VPR, IR soldering, or, if the package is submerged in molten solder, wave soldering. Under certain conditions, the pressure from the expanding moisture and steam can cause internal delamination of the plastic from the chip and/or substrate, internal cracks that do not extend to the outside of the package, band damage, wire necking, bond lifting, thin film cracking, or cratering beneath the bonds. In the most severe case, the stress can result in external package cracks. This is commonly referred to as the "popcom" phenomenon because the internal stress causes the package to bulge and then crack with an audible "pop" sound. Surface mount devices (SMD) are more susceptible to this problem than through-hole parts because SMDs are exposed to higher temperatures during reflow soldering. The reason for this is that the soldering operation must occur on the same side of the circuit board as the surface mount device. For through-hole devices, the soldering operation occurs under the circuit board, which shields the through-hole devices from the hot solder. Also generally, SMDs have a smaller minimum plastic thickness from the chip or mount pad interface to the outside of the plastic package.

Fractures created in the adhesive material, or delamination at the adhesive-substrate interface are the most common causes of SMD package failure. Such a failure is very common in the "popcorn" test, which is a moisture sensitivity test. Conventional SMD packages can only pass the Institute for Interconnecting and Packaging Electronic Circuits (IPC) and the Joint Election Device Engineering Council (JEDEC) Level 3 Moisture Sensitivity Test. Some advanced packages can pass the Level 2 Moisture Sensitivity Test, but the Level 1 Moisture Sensitivity Test remains extremely challenging.

The IPC/JEDEC Moisture Sensitivity Test (the popcorn test) has 3 levels. Level 3 Moisture Sensitivity requires that the SMD package be subjected to 30° C at 60% relative humidity for 192 hours, then cycled through three IR/convection heating cycles, which follow specific requirements. Level 2 Moisture Sensitivity requires that the package be subjected to 85° C at 60% relative humidity for 168 hours and then cycled through three IR/convection heating cycles. Level 1, which is the highest level of moisture insensitivity, requires that the package be subjected to 85° C at 85% relative humidity for 168 hours, then subjected to three cycles of IR/convection heating (See JEDEC document No. JESD22-A112-A *Moisture-Induced Stress Sensitivity for Plastic Surface Mount Devices).*

Various techniques have been used to either limit the amount of humidity a SMD package is subjected to between manufacturing of the package and the time of soldering to a printed circuit card. Techniques have also been used to help the SMD package to pass higher levels of the popcorn test.

To limit the amount of moisture an SMD package is subjected to prior to soldering to a printed circuit board, such packages are packed and shipped in hermetic bags to prevent the absorption of moisture from the environment. For SMD packages that are not packed in hermetic bags or that have been subjected to the environment for sometime, it is an industry standard to bake dry the packages before surface mounting. The additional steps of either placing the SMD packages in hermetic bags, or baking them increases the manufacturing cost of a device or a product.

Plastic and non-hermetic surface mount devices can be seriously damaged from absorbed moisture overpressure when reflow soldered. To prevent this from happening, assemblers have adopted various preventive and reactive approaches. A common strategy involves storing the surface mount devices in dry cabinets that can maintain an atmosphere of less than 5% RH. However, to allow such low RH% in a dynamic environment, one must do so by sweeping the dry cabinets with high flow rates of dry gas (typically N₂). As a result, operating such cabinets becomes expensive in terms of operating costs. In many cases, the N₂ requirements prove to be a hurdle that prevents the establishment of the process in a manufacturing plant.

U.S. 6,560,839, assigned to Integrated Device Technology, Inc, also protects a moisture sensitive component from exposure to moisture above a predetermined threshold level by placing the device into a container with a desiccant and then sealing the container. Once the moisture sensitive components are to be evaluated, the container is unsealed and the components removed from their container. After evaluation, the components are restored to the container, which is then resealed. The above steps are repeated until the components are placed into their container for either shipment, or transportation outside the local testing environment. The protective container is any type of enclosure that minimizes the exposure of moisture-sensitive components to the ambient environment. Due to the effectiveness in stemming moisture accumulation, a baking step is not necessary immediately prior to shipment. Obviously, the repeated opening, testing, and reclosing of the container are added steps which increase the manufacturing and handling costs of the device.

In US-A-5 603 892 a system for maintaining electronic components, such as integrated circuit chips, in a contaminant-free controlled atmosphere is disclosed. The components, which may be mounted on a multichip module, are housed in a sealed enclosure and a positive pressure of contaminant-free gas, such as pure nitrogen, is maintained within the enclosure. A source of pressurized gas, controllably connected to the enclosure is provided and, preferably, an exhaust valve is used to equalize the pressure in the enclosure when it is necessary to access the interior for purposes of maintenance or repair.

Equipment commercialized by Seika Instruments uses a self-desiccant material to dry the atmosphere of a dry cabinet. The Seika Instruments cabinets, however, do not maintain a RH% of less than 5% in a dynamic environment.

### SUMMARY OF THE INVENTION

The present invention is directed to a novel dry cabinet used to store SMDs at low humidity and prevent moisture-induced failures of the devices. In order to reduce the costs associated with prior art dry cabinets, the cabinet of this invention consists of building N₂ or dry gas storage cabinets that include an N₂ or dry gas generation system. The self-contained N₂ or dry gas generation system eliminates the need for a centralized nitrogen or clean dry air system. This lowers the operational costs while eliminating other installation costs associated with an N₂ infrastructure. The cabinet hence becomes independent by self-producing its dry gas needs. This is performed at minimal cost and eliminates other expensive installation costs for the N₂ infrastructure. The add-on compressed air dryer module or N₂ membrane generation system can be installed on all types of dry storage cabinets, small or very large, including cabinets to store trays, bobbins, feeder carts, one-side assembled PWBs, or SMDs.

### BRIEF DESCRIPTION OF THE DRAWINGS

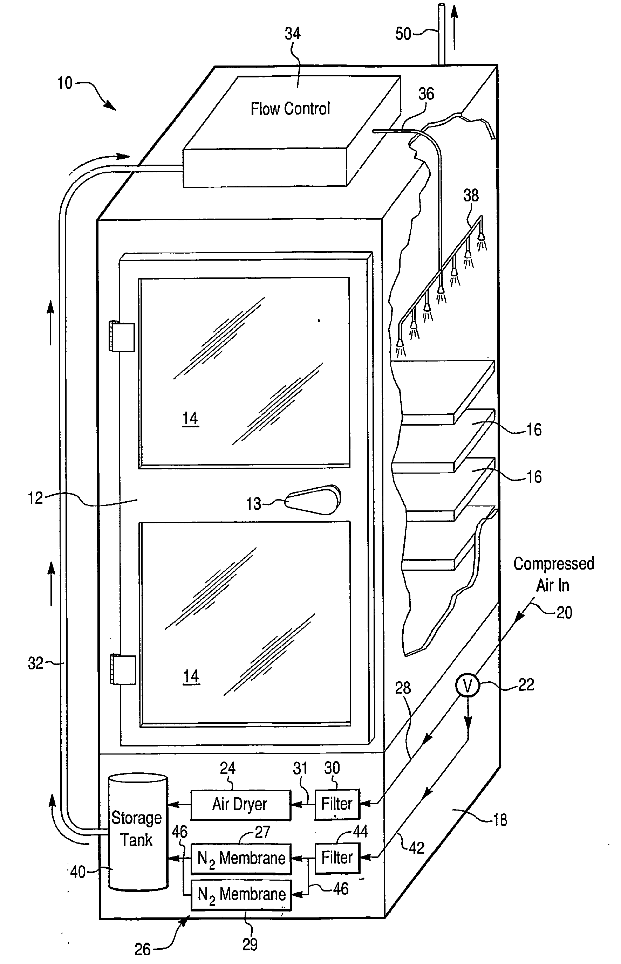

The Figure is a front and side elevational view, partly cut away, of a dry cabinet of this invention containing a self-generating dry gas source.

### DETAILED DESCRIPTION OF THE INVENTION

The introduction of surface mount devices (SMDs) has significantly contributed to the advancement of electronic assembly. Plastic SMDs, especially, have gained extreme popularity as such devices offer versatility and the inherent low cost of plastic packages. These devices, however, have the disadvantage of being sensitive to moisture. Moisture from atmospheric humidity diffuses through the permeable SMD package and if the moisture level inside the package reaches a critical point, the device may be damaged when brought up in the temperature during the reflow soldering process. The rapid increase and high vapor pressure in the package combined with the thermal mismatch stress the component. Typical component failures include die cracking, internal corrosion, bond wire damage, and, in the worst case, external cracking. This is also referred to as the *popcorn effect* due to the audible popping at failure.

To avoid moisture-induced failures and popcorning, it is necessary to scrupulously comply with the floor life recommended by the manufacturer of the component. The moisture sensitivity (MS) level to which the product has qualified (IPC/JEDEC J-STD-033A) indicates the floor life. In everyday practice, this is not always evident for practical reasons (tracking). By way of precaution, and when the floor life has expired, the J-STD-033A specifications recommend to 'bake' the components in order to remove the moisture they have gained from ambient humidity exposure. Baking as per the standard is normally done at an elevated temperature for a period varying from 24 hours (125° C) to 8 days (or more, 40° C). Baking normally concerns only components of level 3 to 6 due to their relatively short floor life.

While baking prevents moisture-induced failures and popcorning, other approaches exist that are more preventive in nature. The revision of IPC/JEDEC J-STD-033 in July, 2002 elaborates on alternative solutions. Typical solutions and strategies frequently involve the use of dry cabinets that can maintain an atmosphere less than 5% RH. However, few of the existing storage cabinets are able to reach and maintain that level in a production environment. The few cabinets that allow such low RH% do so by sweeping the dry cabinets with rather high flow rates of dry gas (typically N₂ from a cryogenic source but dry air or membrane N₂ could be used). As a result, operating such cabinets becomes expensive in terms of the operating costs associated with nitrogen usage. As dry cabinets gain adoption in PCB assembly environments, the need for cabinets that have lower operating costs is emerging. This is particularly critical in plants where nitrogen is not currently available. Installing a centralized nitrogen source can be expensive.

This invention reduces the costs associated with the adequate operation of a dry storage cabinet used for moisture sensitive device management in a PWB assembly environment. The cabinet unit of this invention has a self-generating dry gas source, which only requires some electric power and readily available compressed air. The cabinet unit produces dry gas at a very low marginal cost. Accordingly, the dry box or cabinet can be located anywhere in a PWB assembly plant and does not require the need for a centralized N₂ system.

The dry cabinet of this invention includes a self contained dry gas generation system and is indicated in general, by reference numeral 10 in the Figure. The cabinet 10 typically will contain an access door 12 with handle 13 to open and close door 12 and allow ingress and egress into the interior of the cabinet 10. The access door 12 may include one or more windows or visualization sites 14 to allow the interior of the cabinet to be viewed from the outside. The cabinet 10 will typically contain a plurality of shelves 16 for storing the surface mount devices. Although a rectangular or box shape cabinet is shown in the Figure, the particular shape of the cabinet does not form an important part of the present invention. Although not shown, cabinet 10 can include wheels at the bottom thereof to allow ease of movement of the cabinet around the SMT production facility.

Typically, to maintain a low humidity environment within the cabinet, the prior art directed into the cabinet high flow rates of a dry gas, typically nitrogen, obtained from a centralized source of nitrogen such as a nitrogen supply or a cryogenic type generation system. In the dry cabinet of the present invention, there is provided an integrated dry gas generating system within the cabinet structure. The dry gas generating system receives a source of compressed air whether in the form of a modular source or a centralized source to provide the desired dry gas within the cabinet. The use of a centralized or modular compressed air source and generating the desired dry gas at the cabinet greatly reduces the cost of providing the desired environment within the interior of the dry cabinet relative to the cost of providing the prior art centralized nitrogen or nitrogen-generating sources.

Again, referring to the Figure, compressed air from any available source, whether a modular supply of compressed air or centralized compressed air system, enters the dry cabinet 10 via line 20. A valve 22 can direct the compressed air via line 20 to an air drying system 24 or nitrogen generating system 26, or both, contained within the structure of cabinet 10. The air dryer 24 and nitrogen generation system 26 are built within the base 18 of cabinet 10. The specific location of the dry gas forming system within the dry cabinet 10 is not critical to the invention.

Compressed air via line 20 is directed to either or both the air dryer 24 and nitrogen generator 26 via valve 22. If directed to the air dryer, the compressed air through valve 22 enters line 28 and then a filter 30 so as to remove air borne contaminants such as minute particulates and the like. From the filter 30, the compressed air stream enters the air dryer 24 via line 31. The air dryer 24 is a desiccator, which includes a mass of desiccant, which removes substantially all of the water vapor from the compressed air stream entering cabinet 10 via line 20. As previously stated, it is desired to maintain the environment within the interior of cabinet 10 to a relative humidity of less than 5 %.

Examples of desiccants which may be suitable are included in the list below which is not exhaustive: alumina, aluminum oxide, activated carbon, barium oxide, barium perchlorate, calcium bromide, calcium chloride, calcium hydride, calcium oxide, sulfate, glycerol, glycols, lithium aluminum hydride, lithium bromide, lithium chloride, lithium iodide, magnesium chloride, magnesium perchlorate, magnesium sulfate, molecular sieves, phosphorus pentoxide, potassium hydroxide (fused, sticks, etc.), potassium carbonate, resins, silica gel, sodium hydroxide, sodium iodide, sulfuric acid, titanium silicate, zeolites, zinc bromide, zinc chloride, and combinations of such desiccants. The desiccants may be used in various forms. For example, the desiccant may be a solid and/or a liquid. The desiccant may also comprise part of an aqueous solution.

From air dryer 24, the compressed air stream, now removed of substantially all of the water vapor initially contained therein is directed into the interior of the cabinet to sweep the cabinet and maintain an interior environment containing less than 5% relative humidity. Thus, from the air dryer 24, the dry air is sent via line 32 to a flow controller 34 which can adjust for the volume of dry air directed into the interior of the cabinet via line 36. The flow controller should also include an on/off switch to initiate or stop gas flow if desired. From flow controller 34, and line 36, the dry air is directed to a series of dry gas injectors 38. The injectors 38 direct the dry gas, whether the dry air, or as will be explained below, nitrogen from nitrogen generator 26 into the interior of the cabinet. The exact number and type of gas injectors directing the dry gas into the interior of cabinet 10 is not critical for this particular invention and one of ordinary skill in the art can determine the amount, size and type of dry gas injectors, which would be required for the individual cabinet interior space.

In the Figure, it is shown that the dry air from air dryer 24 can be directed to a storage tank 40 prior to be directed into line 32 and ultimately into the interior of the cabinet. The storage tank 40 is optional and can be used to more accurately control the flow of dry gas into the interior of cabinet 10. Thus, at times, the environment within cabinet 10 may be such that no additional gas is required to be used to sweep the interior of the cabinet. At such times, the dry air or nitrogen can be stored in the optional storage tank 40. Although one storage tank is shown, a separate storage tank for each of the air desiccator 24 or nitrogen generator 26 can be used. Further, a single storage tank with separate and sealed compartments for the dry air and nitrogen, respectively can also be utilized.

Instead of removing the water vapor from the compressed air stream, the dry gas, which is injected into the interior of the cabinet, can be nitrogen formed by a nitrogen generator contained within cabinet 10. Thus, prior to this invention, nitrogen has been used to sweep dry cabinets to maintain an environment of low relative humidity for the storage of SMDs in the cabinets for eventual shipment. However, such cabinets were linked to a centralized nitrogen-generating source, which can be very costly to construct and maintain. Accordingly, in this invention, a modular nitrogen generator is incorporated into the dry cabinet 10 of this invention. The nitrogen generator is shown as reference numeral 26 and generally comprises one or more membrane modules, used for separating nitrogen from the compressed air stream 20 and for producing a concentrated dry nitrogen gas stream. For example, one or more membranes, such as polyimide, polycarbonate, nylon, 6, 6, polystyrene, or cellulose acetate membranes may be used. In this invention, compressed air via line 20 is directed at least in part by valve 22 to line 42 and then through filter 44 to remove particulates from the compressed air stream. From filter 44 and line 46, the filtered compressed air stream is directed to nitrogen generator 26, shown as membrane modules 27 and 29, where the air is treated to separate oxygen from nitrogen in the air stream and produce a highly concentrated N₂ stream.

The permeable membranes that can be employed in the practice of the invention will commonly be employed in membrane assemblies typically positioned within enclosures to form a membrane module comprising the principal element of a membrane system. As understood with reference to the invention, a membrane system comprises a membrane module or a number of such modules, arranged for either parallel (as shown) or series operation. The membrane modules can be constructed in convenient hollow fiber form, or in spiral wound, pleated flat sheet membrane assemblies, or in any other desired configuration. Membrane modules are constructed to have a feed air surface side and an opposite permeate gas exit side. For hollow fiber membranes, the feed air can be added either to the lumen side or to the outer surface side of the hollow fibers.

It will also be appreciated that the membrane material employed for the air separation membrane can be any suitable material capable of selectively permeating a more readily permeable component of the feed gas, i.e. air. Cellulose derivatives, such as cellulose acetate, cellulose acetate butyrate and the like; polyamides and polyimides, including aryl polyamides and aryl polyimides; polysulfones; polystyrenes and the like, are representative of such materials.

As indicated above, the permeable membranes comprising the membrane system positioned within cabinet 10 of the invention may be in any desirable form, with hollow fiber membranes being generally preferred. !t will be appreciated that the membrane material employed in any particular gas separation application can be any suitable material capable of selectively permeating a more readily permeable component of a gas of fluid mixture containing a less readily permeable component. The polymers discussed immediately above are representative examples of such materials. It will be understood in the art that numerous other permeable membrane materials are known in the art and suitable for use in a air separation. As noted, the membranes, as employed in the practice of the invention, may be in any such form that is useful and effective for the air separation being carried out using the system and process of the invention.

One is a so-called "composite membrane" in which the active layer is positioned coextensively adjacent to a structurally supportive and usually porous substrate. In a composite membrane the active layer and the substrate are not partial elements of a single, monolithic layer. They usually are produced by laying up one layer on another, such as by laminating two separate layers. The substrate can be a selectively gas permeable material but typically is not. As mentioned, due to porosity the substrate has negligible gas separation properties and presents little resistance to transmembrane flux. The substrate primarily provides structural integrity for the active layer which is by itself normally too thin to form a self supporting film or to withstand the pressure gradient across the membrane imposed during routine operation.

A preferred type of membrane is known as an asymmetric membrane. This membrane is characterized by an anisotropic structure in cross section normal to direction of permeate flow. Typically an asymmetric membrane has an active layer constituted by a continuous, dense thin skin at one surface and a porous, usually thicker support layer coextensively adjacent to the skin and tending to be increasingly porous with distance from the skin. The active layer and support layer of the asymmetric membrane are usually composed of the same selectively gas permeable substance. The skin is usually less than 1/10th of the thickness of the asymmetric membrane. Typically, the thickness of the skin is about 50-3000 Å, preferably about 50-1500 Å and more preferably about 50-1000 Å. The asymmetric membrane can be either monolithic or composite. That is, in a monolithic asymmetric membrane the active layer and support layer are parts of an integrated monolithic structure. In a composite asymmetric membrane, the asymmetric membrane includes a substrate adjacent to the asymmetric membrane layer. For example, a typical hollow fiber composite membrane can be formed by an annular core of a porous substrate surrounded by a coaxial annular sheath of the asymmetric membrane. In a composite asymmetric membrane the non-active layer of the asymmetric membrane and the substrate layer are sometimes collectively referred to as the "support layer". The asymmetric membrane layer and the substrate typically have different compositions.

Materials used for gas separation membranes are frequently polymeric. A diverse variety of polymers can be used for the supportive substrate of a composite membrane. Representative substrate polymers include polysulfones, polyether sulfones, polyamides, polyimides, polyetherimides, polyesters, polycarbonates, copolycarbonate esters, polyethers, polyetherketones, polyvinylidene fluoride, polybenzimidazoles, polybenzoxazoles, cellulosic derivatives, polyazoaromatics, poly(2,6-dimethylphenylene oxide), polyarylene oxide, polyureas, polyurethanes, polyhydrazides, polyazomethines, cellulose acetates, cellulose nitrates, ethyl cellulose, brominated poly(xylylene oxide), sulfonated poly(xylylene oxide), polyquinoxaline, polyamideimides, polyamide esters, blends thereof, copolymers thereof, substituted materials thereof and the like. This should not be considered limiting since any material which can be fabricated into an anisotropic substrate membrane may find utility as the substrate layer of the present invention. Preferred materials for the substrate layer include polysulfone, polyethersulfone, polyetherimide, polyimide, polyamide compositions and copolymers and blends thereof.

A wide range of polymeric materials have desirable selectively gas permeating properties and can be used in the active layer. Representative materials include polyamides, polyimides, polyesters, polycarbonates, copolycarbonate esters, polyethers, polyetherketones, polyetherimides, polyethersulfones, polysulfones, polyvinylidene fluoride, polybenzimidazoles, polybenzoxazoles, polyacrylonitrile, cellulosic derivatives, polyazoaromatics, poly(2,6-dimethylphenylene oxide), polyphenylene oxide, polyureas, polyurethanes, polyhydrazides, polyazomethines, polyacetals, cellulose acetates, cellulose nitrates, ethyl cellulose, styrene-acrylonitrile copolymers, brominated poly(xylylene oxide), sulfonated poly(xylylene oxide), tetrahalogen-substituted polycarbonates, tetrahalogen-substituted polyesters, tetrahalogen-substituted polycarbonate esters, polyquinoxaline, polyamideimides, polyamide esters, blends thereof, copolymers thereof, substituted materials thereof, and the like. In addition, suitable gas separating layer membrane materials may include those found useful as the dense separating layer of composite gas separation membranes. These materials include polysiloxanes, polyacetylenes, polyphosphazenes, polyethylenes, poly(4-methylpentene), poly(trimethylsilylpropyne), poly(trialkylsilylacetylenes), polyureas, polyurethanes, blends thereof, copolymers thereof, substituted materials thereof, and the like. Preferred materials for the dense gas separating layer include aromatic polyamide, aromatic polyimide compositions, polysufone, polyether sulfone and blends thereof.

Hollow fiber membranes with dense regions are preferred for gas separation. Asymmetric hollow fiber membranes may have the discriminating region either on the outside of the hollow fiber, at the inside (lumen surface) of the hollow fiber, or located somewhere internal to both outside and inside hollow fiber membrane surfaces. In the embodiment wherein the discriminating region of the hollow fiber membrane is internal to both hollow fiber membrane surfaces, the inside (lumen) surface and the outside surface of the hollow fiber membrane are porous, yet the membrane demonstrates the ability to separate gases. In the embodiment wherein gases are separated, the preferred polymeric materials for membranes include polyestercarbonates, polysulfones, polyethersulfones, polyimides, and polycarbonates. More preferred polymeric materials for gas separation membranes include polycarbonates and polyestercarbonates. Preferred polycarbonate and polyestercarbonate membranes for gas separation include those described in U.S. Pat. Nos. 4,874,401; 4,851,014; 4,840,646 and 4,818,254; the relevant portions of each patent incorporated herein by reference for all legal purposes which may be served thereby. In one preferred embodiment, such membranes are prepared by the process described in U.S. Pat. No. 4,772,392, the relevant portions incorporated herein by reference for all legal purposes, which may be served thereby. Particularly useful membranes for the air seperation and generation of a concentrated dry N₂ gas stream are hollow fiber polymeric membranes produced by the present assignee, Air Liquide, under the tradename MEDAL.

The concentrated nitrogen gas stream is separated from the compressed air and is substantially dry as the water vapor is also separated from the nitrogen component stream by the membrane. The dry nitrogen gas stream leaving generator 26 via line 48 can be optionally stored in storage tank 40 prior to being directed via line 32, flow controller 34 and line 36 to the dry gas injectors 38. Again, a separate tank 40 can be used to store the N₂ gas stream from the nitrogen generator 26 relative to storage of dry air from the air dryer 24. Nitrogen generating systems with bulk storage and flow control are known in the art and are particularly described in U.S. Pat. Nos. 5,266,101; 5,284,506; 5,302,189; 5, 363,656; 5,439,507; and 5,496,388, the entire contents of which are herein incorporated by reference.

While the nitrogen generating system 26 has been described as comprising one or more membrane structures, or membrane modules, it is also possible to form a concentrated nitrogen gas stream from compressed air utilizing a particulate adsorbents in known pressure swing adsorption (PSA) systems. Thus, particulate adsorbents such as activated carbon, silica gels, and molecular sieves, such as zeolite and titania siliates, i.e. CTS-1, are known for separation of air into its individual components including formation of a concentrated nitrogen gas stream. Accordingly, the nitrogen generating system 26, which is incorporated into cabinet 10, can include one of more beds of adsorbent which under selective pressure conditions can adsorb oxygen or nitrogen and produce a concentrated dry nitrogen gas stream. Operation of PSA systems are known in the art in which cycles of pressurization (adsorption), depressurization (regeneration), and equalization of pressure are used to adsorb a gaseous component from a mixture and regenerate the adsorbed component form the adsorbent bed. U.S. Pat. No. 4,933,314 describes a particular molecular sieve carbon used for separating nitrogen or oxygen from air. U.S. Pat. No. 5,288,888 directed to producing a nitrogen enriched product by passing air through a bed of crushed zeolite and U.S. Pat. No. 6,068,682 which discloses crystalline titanium molecular sieves, CTS-1 are examples of known adsorbents which can be used to form a concentrated nitrogen stream from air. Each of these listed U.S. patents are herein incorporated by reference in their entirety.

Similar to the membrane separation system, a concentrated nitrogen gas stream leaving a PAS module can optionally be stored in storage tank 40 and then directed to the dry gas injectors 38 via line 32, flow controller 34 and line 36.

It will be understood that while the dry cabinet 10 is particularity useful for storing surface mount devices during or after assembly, the dry cabinet of this invention has further use in preventing any type of device from being adversely affected by humid air during storage or transport before being utilized. In particular, any type of semiconductor, electronic, optical or magnetic component and the like can be stored in cabinet 10. The environment is free from water vapor, which can permeate any packaging or any pores in the device structure and cause permanent damage while in storage or during installation and use.

The dry gas, having swept the interior of cabinet 10 to maintain a very low relative humidity within the interior of the cabinet is released form the cabinet via line 50. Again, the control of the compressed air through line 20, valve 22 or any optional storage tank 40 and flow control 34 can maintain the desired pressure and low humidity conditions within the interior of cabinet 10. Thus, a gas leaving the interior of cabinet 10 via line 50 can be on a continuous or even intermittent basis.

While there has been described and illustrated several preferred embodiments of the present invention it will be apparent to those skilled in the art that variations and modifications are possible without the deviating form the broad scope of the present invention which shall be limited solely by the scope of the claims appended here too.

## Claims

1. A cabinet having an enclosed interior space for storing surface mount devices in an environment of low relative humidity comprising; a desiccator, a nitrogen generator or both associated with said cabinet and transportable therewith, means to receive a supply of compressed air communicating with said desiccator or said nitrogen generator or both and means to direct a dry gas stream from said desiccator or said nitrogen generator into the interior of the said cabinet to maintain a low humidity environment in said interior space.

2. The cabinet of claim 1 including said nitrogen generator.

3. The cabinet of claim 2 wherein said nitrogen generator comprises a membrane capable of separating air to form a concentrated nitrogen gas stream.

4. The cabinet of claim 3 wherein said membrane comprising a polymeric membrane.

5. The cabinet of claim 4 wherein said membrane is a hollow fiber polymeric membrane.

6. The cabinet of claim 3 comprising a plurality of said membranes

7. The cabinet of claim 2 wherein said nitrogen generator comprises a particulate adsorbent capable of adsorbing one or more components of air and form a concentrated nitrogen gas stream.

8. The cabinet of claim 7 wherein said concentrated nitrogen gas stream is formed by a pressure swing adsorption system.

9. The cabinet of claim 1 including said desiccator.

10. The cabinet of claim 1 including both said desiccator and said nitrogen generator.

11. The cabinet of claim 1 wherein said desiccator and/or nitrogen generator is an integral part of said cabinet.

12. The cabinet of claim 11 containing a flow controller to vary the volume of said dry gas stream directed into the interior of said cabinet.

13. The cabinet of claim 1 further containing a storage means for storing said dry gas stream from said desiccator, said nitrogen generator or both.

14. The cabinet of claim 1 further including a filter to remove particulates from said compressed air received from said supply.

15. A method of storing surface mount devices in the interior of a cabinet and maintaining a low relative humidity in the interior of said cabinet comprising: directing a supply of compressed air to a dry gas forming means in the form of a desiccator or a nitrogen generator associated with said cabinet and transportable therewith, forming a dry air gas stream or a dry nitrogen gas stream from said dry gas forming means and directing said dry air or dry nitrogen stream into the interior of said cabinet so as to maintain a low relative humidity in the interior space of said cabinet while storing said surface mount devices.

16. The method of claim 15 comprises forming a dry nitrogen gas stream by directing said compressed air stream to said nitrogen generator.

17. The method of claim 16 wherein said dry nitrogen gas stream is formed by membrane separation of said compressed air stream.

18. The method of claim 15 wherein the relative humidity in the interior of said cabinet is maintained at 5% or less.

19. The method of claim 15 wherein said dry gas stream is a dry air stream formed by directing said compressed air stream to said desiccator.

20. The method of claim 15 wherein said dry gas forming means is an integral part of said cabinet.

## Patentansprüche

1. Schrank mit einem umschlossenen Innenraum zur Aufbewahrung oberflächenmontierter Vorrichtungen in einer Umgebung mit niedriger relativer Feuchtigkeit, aufweisend: einen Exsikkator, einen Stickstoffgenerator oder beides, die mit dem Schrank assoziiert und mit diesem transportierbar sind, Mittel zur Aufnahme einer Zufuhr von Druckluft, die mit dem Exsikkator oder dem Stickstoffgenerator oder beiden in Verbindung steht, und Mittel zum Führen eines Trockengasstroms aus dem Exsikkator oder dem Stickstoffgenerator in das Innere des Schranks, um in dem Innenraum eine Umgebung mit niedriger Feuchtigkeit aufrechtzuerhalten.

2. Schrank nach Anspruch 1, der den Stickstoffgenerator enthält.

3. Schrank nach Anspruch 2, wobei der Stickstoffgenerator eine Membran aufweist, die Luft trennen kann, um einen konzentrierten Stickstoffgasstrom zu bilden.

4. Schrank nach Anspruch 3, wobei die Membran eine polymere Membran aufweist.

5. Schrank nach Anspruch 4, wobei die Membran eine polymere Hohlfasermembran ist.

6. Schrank nach Anspruch 3, der mehrere der Membranen aufweist.

7. Schrank nach Anspruch 2, wobei der Stickstoffgenerator ein teilchenförmiges Adsorbens aufweist, das eine oder mehrere Komponenten der Luft adsorbieren kann und einen konzentrierten Stickstoffgasstrom bildet.

8. Schrank nach Anspruch 7, wobei der konzentrierte Stickstoffgasstrom durch ein Druckwechsel-Adsorptionssystem gebildet wird.

9. Schrank nach Anspruch 1, der den Exsikkator enthält.

10. Schrank nach Anspruch 1, der sowohl den Exsikkator als auch den Stickstoffgenerator enthält.

11. Schrank nach Anspruch 1, wobei der Exsikkator und/oder der Stickstoffgenerator ein integraler Teil des Schranks ist.

12. Schrank nach Anspruch 11, der einen Durchflussregler enthält, um das Volumen des in das Innere des Schranks geführten Trockengasstroms zu variieren.

13. Schrank nach Anspruch 1, der ferner ein Aufbewahrungsmittel enthält, um den Trockengasstrom aus dem Exsikkator, dem Stickstoffgenerator oder beiden aufzubewahren.

14. Schrank nach Anspruch 1, der ferner einen Filter enthält, um Teilchenmaterialien aus der von der Zufuhr erhaltenen Druckluft zu entfernen.

15. Verfahren zum Aufbewahren von oberflächenmontierten Vorrichtungen im Inneren eines Schranks und zum Aufrechterhalten einer niedrigen relativen Feuchtigkeit in dem Inneren des Schranks, aufweisend: Führen einer Zufuhr von Druckluft zu einem Trockengas bildenden Mittel in Form eines Exsikkators oder Stickstoffgenerators, das mit dem Schrank assoziiert und mit diesem transportierbar ist, Bilden eines Trockenluftgasstroms oder eines Trockenstickstoffgasstroms aus dem Trockengas bildenden Mittel und Führen des Trockenluft- oder Trockenstickstoffstroms in das Innere des Schranks, um so während der Aufbewahrung der oberflächenmontierten Vorrichtungen eine niedrige relative Feuchtigkeit in dem Innenraum des Schranks aufrechtzuerhalten.

16. Verfahren nach Anspruch 15, wobei ein Trockenstickstoffgasstrom gebildet wird, indem der Druckluftstrom zu dem Stickstoffgenerator geführt wird.

17. Verfahren nach Anspruch 16, wobei der Trockenstickstoffgasstrom durch Membrantrennung des Druckluftstroms gebildet wird.

18. Verfahren nach Anspruch 15, wobei die relative Feuchtigkeit im Inneren des Schranks auf 5 % oder weniger gehalten wird.

19. Verfahren nach Anspruch 15, wobei der Trockengasstrom ein Trockenluftstrom ist, der durch Führen des Druckluftstroms zu dem Exsikkator gebildet wird.

20. Verfahren nach Anspruch 15, wobei das Trockengas bildende Mittel ein integraler Teil des Schranks ist.

## Revendications

1. Armoire qui présente un espace intérieur clos pour le stockage de dispositifs de montage de surface dans un environnement à basse humidité relative, qui comprend : un dessiccateur, un générateur d'azote ou les deux associés à l'armoire et transportables avec elle, des moyens pour recevoir une réserve d'air comprimé qui communique avec ledit dessiccateur ou ledit générateur d'azote ou les deux et des moyens pour envoyer directement l'écoulement de gaz sec qui provient dudit dessiccateur ou dudit générateur d'azote à l'intérieur de ladite armoire afin de maintenir un environnement à basse humidité dans ledit espace intérieur.

2. Armoire selon la revendication 1, qui comprend ledit générateur d'azote.

3. Armoire selon la revendication 2, dans laquelle ledit générateur d'azote comprend une membrane capable de séparer l'air afin de former un écoulement d'azote gazeux concentré.

4. Armoire selon la revendication 3, dans laquelle ladite membrane est une membrane en polymère.

5. Armoire selon la revendication 4, dans laquelle ladite membrane est une membrane en polymère à fibres creuses.

6. Armoire selon la revendication 3, qui comprend plusieurs desdites membranes.

7. Armoire selon la revendication 2, dans laquelle ledit générateur d'azote comprend un adsorbant en particules capable d'adsorber un ou plusieurs composants de l'air et de former un écoulement d'azote gazeux concentré.

8. Armoire selon la revendication 7, dans laquelle ledit écoulement d'azote gazeux concentré est formé par un système d'adsorption qui travaille sous pression alternée.

9. Armoire selon la revendication 1, qui comprend ledit dessiccateur.

10. Armoire selon la revendication 1, qui comprend aussi bien ledit dessiccateur que ledit générateur d'azote.

11. Armoire selon la revendication 1, dans laquelle ledit dessiccateur et/ou ledit générateur d'azote font partie intégrante de ladite armoire.

12. Armoire selon la revendication 11, qui comprend un contrôleur d'écoulement qui fait varier le débit dudit écoulement de gaz sec dirigé vers l'intérieur de ladite armoire.

13. Armoire selon la revendication 1, qui comprend de plus un moyen de stockage qui stocke ledit écoulement de gaz sec provenant dudit dessiccateur, dudit générateur d'azote ou des deux.

14. Armoire selon la revendication 1, qui comprend de plus un filtre qui permet d'enlever les particules dudit air comprimé délivré par ladite alimentation.

15. Procédé de stockage de dispositifs de montage de surface situés à l'intérieur d'une armoire et qui permet de maintenir une basse humidité relative à l'intérieur de ladite armoire, le procédé comprenant les étapes qui consistent à :
envoyer une alimentation d'air comprimé dans un moyen de préparation de gaz sec qui présente la forme d'un dessiccateur ou d'un générateur d'azote associés à ladite armoire et transportables avec elle,
former un écoulement d'air sec ou un écoulement d'azote gazeux sec à partir desdits moyen de préparation d'un gaz sec et
envoyer ledit écoulement d'air sec ou d'azote sec vers l'intérieur de ladite armoire de manière à maintenir une basse humidité relative dans l'espace intérieur de ladite armoire pendant le stockage desdits dispositifs de montage de surface.

16. Procédé selon la revendication 15, qui comprend la formation d'un écoulement gazeux d'azote sec en dirigeant ledit écoulement d'air comprimé vers ledit générateur d'azote.

17. Procédé selon la revendication 16, dans lequel ledit écoulement gazeux d'azote sec est formé par séparation par membrane dudit écoulement d'air comprimé.

18. Procédé selon la revendication 15, dans lequel l'humidité relative à l'intérieur de ladite armoire est maintenue à 5 % ou moins.

19. Procédé selon la revendication 15, dans lequel ledit écoulement de gaz sec est un écoulement d'air sec formé en dirigeant ledit écoulement d'air comprimé vers ledit dessiccateur.

20. Procédé selon la revendication 15, dans lequel ledit moyen de formation du gaz sec fait partie intégrante de ladite l'armoire.
